# FASCICULE DE BREVET EUROPEEN

(11) **EP 1 903 616 B1**
(45) Date de publication et mention de la délivrance du brevet: **17.01.2018**
(21) Numéro de dépôt: 07116755.5
(22) Date de dépôt: 19.09.2007
(51) Int. Cl.: H01L 31/18

(54) **Procédé de recuit de cellules photovoltaiques**
Verfahren zum Tempern von Sperrschichtphotozellen
Method of annealing photovoltaic cells

(30) Priorité: 21.09.2006 FR 0653882
(43) Date de publication de la demande: 26.03.2008
(73) Titulaire: Commissariat à l'Énergie Atomique et aux Énergies Alternatives, 75015 Paris (FR)
(72) Inventeur: Enjalbert, Nicolas, 38630, Les Avenirs (FR); Dubois, Sébastian, 38000, Grenoble (FR)
(74) Mandataire: Ahner, Philippe

(56) Documents cités:
- US-A1- 2005 189 015
- DHUNGEL S K ET AL: "Effect of pressure on surface passivation of silicon solar cell by forming gas annealing", MATERIALS SCIENCE IN SEMICONDUCTOR PROCESSING, ELSEVIER SCIENCE PUBLISHERS B.V., BARKING, UK, vol. 7, no. 4-6, 2004, pages 427-431, XP004639177, ISSN: 1369-8001

## Description

### DOMAINE TECHNIQUE ET ART ANTÉRIEUR

L'invention concerne le domaine des cellules photovoltaïques et plus particulièrement un procédé de recuit de cellules photovoltaïques.

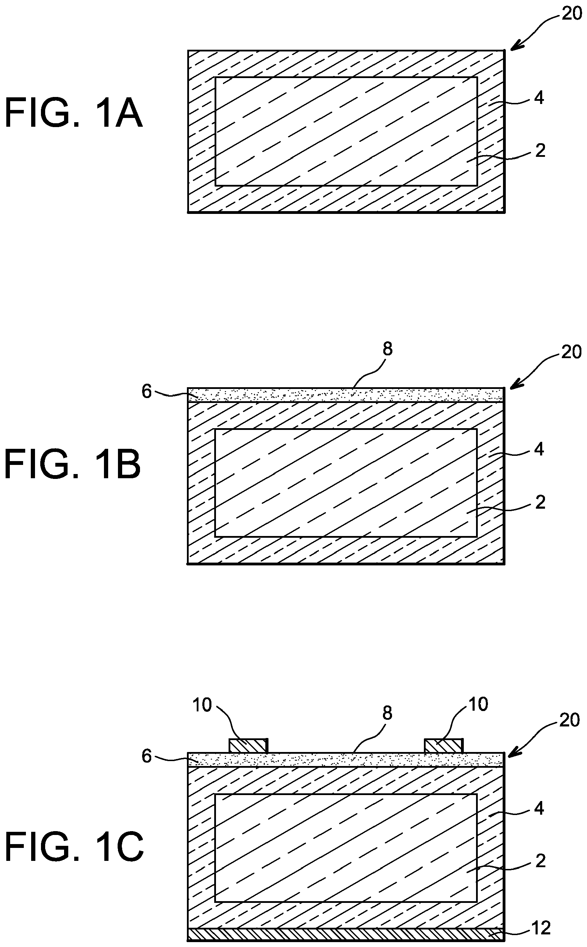

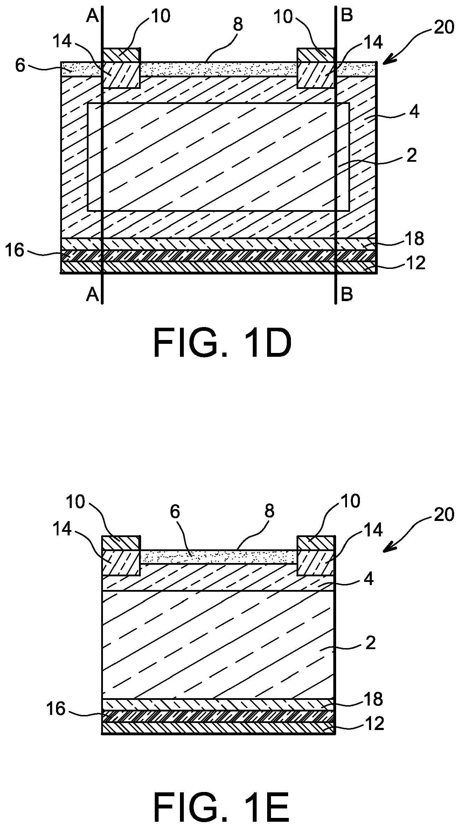

Un procédé standard utilisé pour la production industrielle d'une cellule photovoltaïque 20 à base de silicium cristallin (monocristallin ou multicristallin) de type P ou N est représenté sur les figures 1A à 1E. Un substrat 2 de type N ou P subit tout d'abord une texturation de ses surfaces par l'utilisation d'une solution d'hydroxyde de potassium, permettant de réduire la réflectivité de ces surfaces et ainsi d'obtenir un meilleur confinement optique des faisceaux entrants dans le substrat 2. Une couche 4 de type N+ est formée dans le substrat 2 par diffusion de phosphore au niveau de toutes les faces du substrat 2 (figure 1A). Une couche antireflet 6 de nitrure de silicium riche en hydrogène (*SiN* - *H*) est ensuite déposée sur la couche N+ 4 par dépôt chimique en phase vapeur assisté par plasma (PECVD), comme représenté sur la figure 1B, formant une face avant 8 de la cellule photovoltaïque 20. Des métallisations en argent 10 et en aluminium 12 sont formées par sérigraphie respectivement sur la face avant 8 et sur la face arrière du substrat 2 (figure 1C). Enfin, ces métallisations 10, 12 subissent un recuit dans un four à passage infrarouge, formant des contacts 14 entre les métallisations avant 10 et la couche N+ 4, ainsi qu'une couche 16 à base d'un alliage d'aluminium et de silicium, et d'une couche 18 de type P+ dans le substrat 2, venant remplacer une partie de la couche N+ 4 sous la métallisation arrière 12.

Enfin, comme représenté sur la figure 1E, on supprime les portions de la couche N+ 4 reliant la couche 18 aux contacts 14, c'est-à-dire reliant électriquement les métallisations 10 de la face avant à la couche de métallisation 12 de la face arrière. Sur la figure 1E, tous les éléments de la cellule photovoltaïque 20 se trouvant du côté extérieur des plans AA et BB sont supprimés, par exemple par laser, plasma, enrobage ou tout autre moyen de gravure.

Dans le cas d'un substrat 2 de type P, la partie de la couche N+ 4 restante et le substrat 2 forment la jonction PN de la cellule photovoltaïque 20. La couche P+ 18 permet la passivation de la face arrière du substrat 2 par un effet de champ arrière (BSF) repoussant des porteurs minoritaires, ici des électrons, dans le substrat 2. Dans le cas d'un substrat 2 de type N, c'est la couche P+ 18 et le substrat 2 qui forment la jonction PN de la cellule photovoltaïque 20, et la couche N+ 4 réalise la passivation de la face avant du substrat 2 par un effet de champ avant (FSF) repoussant des porteurs minoritaires, ici des trous, dans le substrat 2, la couche antireflet 6 contribuant également à cette passivation. Le document « N-type multicrystalline silicon for solar cells » de S. Martinuzzi et al, 20th EPSEC, 2005, Barcelone, pages 631 à 634, décrit une telle cellule photovoltaïque, la température de recuit décrite étant comprise entre 850°C et 900°C.

Lors du recuit, de l'hydrogène migre sous forme d'ions à partir de la couche antireflet 6 riche en hydrogène sur quelques micromètres avant de former de l'hydrogène moléculaire *H*₂ dont la diffusion est limitée dans le silicium du substrat 2 et qui n'a pas la propriété, comme les ions hydrogène, de passiver les défauts cristallographiques et les impuretés. Or, lors de la formation de la couche en alliage 16, des lacunes migrent dans le substrat 2 et permettent la dissociation des molécules *H*₂, permettant aux ions hydrogène de diffuser beaucoup plus profondément dans le substrat 2, améliorant la durée de vie des porteurs dans le substrat 2 et donc, améliorant également le rendement de conversion de la cellule photovoltaïque 20. Cette couche en alliage 16 permet également d'améliorer la qualité du silicium du substrat 2 par effet getter, les impuretés étant piégées par un mécanisme de ségrégation. Ce phénomène d'hydrogénation lors du recuit est décrit dans le document « Hydrogen passivation of defects in multicrystalline silicon solar cells » de S. Martinuzzi et al, Solar Energy Materials & Solar Cells, vol. 80, pages 343 à 353, 2003.

La diffusion de l'hydrogène dans le substrat 2 est particulièrement efficace lorsque les densités de défauts cristallographiques étendus, tels que des dislocations ou des joints de macle, sont importantes. La passivation par l'hydrogène est très utile lorsque les concentrations d'impuretés, principalement métalliques, sont importantes, par exemple dans les matériaux élaborés à partir de charges de mauvaise qualité (charges de silicium métallurgique), ou les matériaux riches en dislocations comme ceux issus de coulées continues électromagnétiques ou de tirages en ruban.

Le document « Ribbon Si solar cells with efficiencies over 18 % by hydrogenation of defects », de D.S. Kim et al., Solar Energy Materials & Solar Cells, vol. 90, pages 1227 à 1240, 2006, décrit un recuit de la face arrière d'une cellule photovoltaïque à une température comprise entre 700°C et 800°C dans un four de type RTP (rapid thermal processing en anglais, ou à traitement thermique rapide). Dans l'exemple décrit, les métallisations en face avant sont réalisées par photolithographie et gravure d'une couche antireflet, et évaporation de titane, palladium et argent. La cellule obtenue offre un rendement légèrement supérieur à 18% avec un substrat multicristallin de silicium de type P obtenu par tirage en rubans mais le procédé proposé n'est économiquement pas viable et difficilement transférable dans l'industrie.

Le document « Effect of pressure on surface passivation of silicon solar cell by forming gas annealing » de S.K. Dhungel et al, Materials Science In Semiconductor Processing, vol. 7, pages 427 à 431, 2004, décrit un second recuit réalisé après un premier recuit d'un procédé de réalisation de cellule photovoltaïque tel que décrit ci-dessus. Ce second recuit est réalisé dans un four à tube comportant du gaz (*H*₂ et *N*₂) sous pression (3 Pa). Ce type de recuit est appelé « forming gas annealing » en anglais, ou FGA, et vise dans ce document à incorporer de l'hydrogène dans la couche antireflet de la cellule photovoltaïque, afin d'améliorer les qualités de passivation de l'interface couche antireflet - couche dopée dans la cellule photovoltaïque.

Le document US20050189015 décrit un procédé de fabrication de cellules solaire à base de silicium comportant deux recuits successifs après le dépôt des couches passivantes et des électrodes (voir en particuler la figure 39), le premier recuit étant un recuit rapide à 700°C et le second recuit étant effectué à 400°C sous atmosphère H₂+N₂.

### EXPOSÉ DE L'INVENTION

Un but de la présente invention est de proposer un procédé de recuit de cellules photovoltaïques permettant d'obtenir des cellules photovoltaïques ayant un meilleur rendement que les cellules réalisées selon les procédés de l'art antérieur décrits précédemment, et qui soit économiquement viable dans l'industrie.

Pour cela, la présente invention propose un procédé de recuit d'au moins une cellule photovoltaïque comportant un substrat à base de semi-conducteur, par exemple du silicium, d'un premier type de conductivité, une couche dopée d'un second type de conductivité réalisée dans le substrat et formant une face avant du substrat, une couche antireflet réalisée sur la face avant du substrat et formant une face avant de la cellule photovoltaïque, au moins une métallisation sur la face avant de la cellule photovoltaïque et au moins une métallisation sur une face arrière du substrat, ledit procédé comportant au moins les étapes de :
a) premier recuit de la cellule photovoltaïque à une température comprise entre environ 700°C et 900°C,
b) second recuit de la cellule photovoltaïque à une température comprise entre environ 200°C et 500°C, à pression ambiante et à l'air ambiant,
de l'hydrogène étant diffusé dans le substrat durant le procédé.

On entend par « pression ambiante », ici et dans tout le reste du document, une pression standard d'environ 1 bar. Cela signifie que le second recuit n'est pas réalisé dans une enceinte dans laquelle une pression, différente de la pression de l'environnement extérieur, est appliquée. On entend également par « à l'air ambiant », ici et dans tout le reste du document, que le second recuit n'est pas réalisé dans une enceinte dans laquelle des gaz différents de l'air de l'environnement extérieur ambiant sont présents.

Ainsi, selon l'invention, la cellule photovoltaïque subit au moins deux étapes successives de recuit. Le premier recuit, de façon similaire aux procédés de l'art antérieur, permet la migration d'hydrogène sous forme ionique à partir de la couche antireflet dans le substrat si cette couche antireflet est riche en hydrogène. L'hydrogène diffusé dans le substrat peut également être obtenu par une étape d'hydrogénation du substrat. Le second recuit, qui est réalisé à une température bien plus basse que le premier recuit, permet à l'hydrogène diffusé de former des liaisons supplémentaires avec des défauts cristallographiques ou des impuretés présents dans le substrat. Ainsi, la durée de vie des porteurs dans le substrat est allongée, augmentant ainsi le rendement de conversion photovoltaïque de la cellule. De plus, ce second recuit ne nécessite aucune contrainte de pression ou de gaz, contrairement aux recuits sous *H*₂ et *N*₂ de l'art antérieur, ce qui représente un avantage économique important.

Le second recuit a principalement pour objectif l'amélioration des propriétés volumiques du substrat en favorisant la formation de liaisons entre l'hydrogène présent dans le substrat et les défauts cristallographiques ou impuretés.

Ce procédé est donc particulièrement adapté à la réalisation de cellules photovoltaïques comportant des substrats obtenus à partir de charges de moindre qualité et de matériaux riches en dislocations, par exemple du silicium issu d'une coulée continue électromagnétique et d'un tirage en ruban.

La présente invention concerne également un procédé de réalisation d'au moins une cellule photovoltaïque, comportant au moins les étapes de :
- texturation des surfaces d'un substrat à base de semi-conducteur, par exemple du silicium, d'un premier type de conductivité,
- formation d'une couche dopée d'un second type de conductivité dans le substrat formant une face avant du substrat,
- dépôt d'une couche antireflet sur la face avant du substrat, ladite couche formant une face avant de la cellule photovoltaïque,
- réalisation d'au moins une métallisation sur la face avant de la cellule photovoltaïque,
- réalisation d'au moins une métallisation sur une face arrière du substrat,
- mise en oeuvre d'un procédé de recuit tel que décrit précédemment, également objet de la présente invention,
- suppression d'au moins une partie de la couche dopée du second type de conductivité reliant électriquement la métallisation de la face avant à la métallisation de la face arrière de la cellule photovoltaïque.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1E déjà décrites représentent les étapes d'un procédé de réalisation d'une cellule photovoltaïque selon l'art antérieur,
- les figures 2A à 2C représentent les étapes d'un procédé de recuit d'une cellule photovoltaïque, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

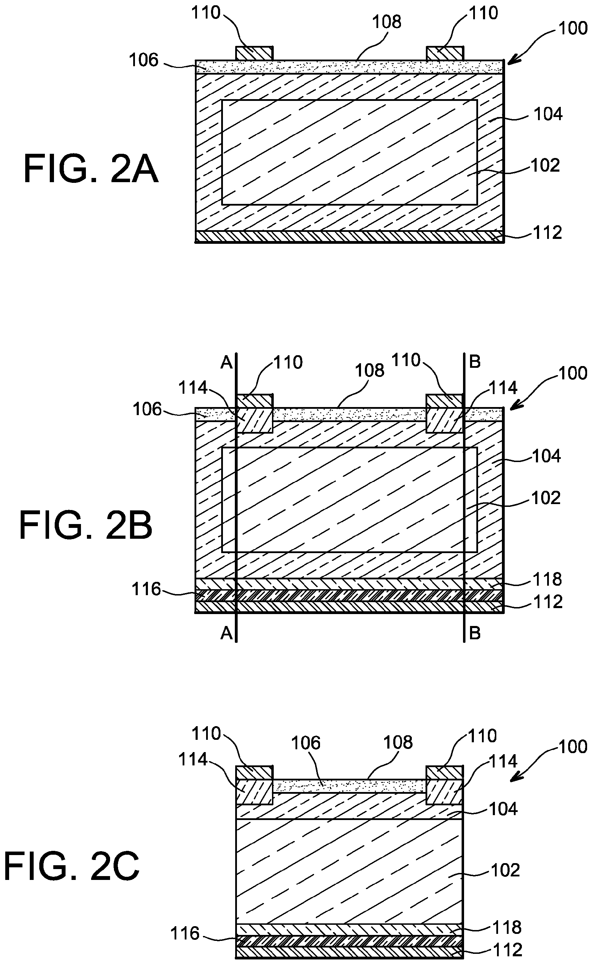

On se réfère aux figures 2A à 2C représentant les étapes d'un procédé de recuit d'une cellule photovoltaïque 100. Les étapes d'un procédé de réalisation de cellule photovoltaïque 100 vont également être décrites en liaison avec ces figures.

Un substrat 102 d'un premier type de conductivité, par exemple à base de silicium multicristallin ou monocristallin de type P, est représenté sur la figure 2A. Pour la réalisation de la cellule photovoltaïque 100, on réalise tout d'abord une texturation des surfaces du substrat 2 par l'utilisation d'une solution d'hydroxyde de potassium. Une couche 104 dopée d'un second type de conductivité, par exemple de type N+, est ensuite formée par diffusion de phosphore dans le substrat 102. Cette couche 104 forme notamment une face avant du substrat 102 sur laquelle est déposée, par exemple par PECVD, une couche antireflet 106, par exemple riche en hydrogène et à base de nitrure de silicium ou de carbure de silicium, et formant une face avant 108 de la cellule photovoltaïque 100. La jonction PN de la cellule photovoltaïque 100 est formée par le substrat 102 de type P et la couche N+ 104.

Durant le procédé de recuit de la cellule photovoltaïque 100, de l'hydrogène est diffusé dans le substrat 102. Cet hydrogène peut par exemple provenir de la couche antireflet 106 lorsque celle-ci est riche en hydrogène. Cet hydrogène peut également être présent dans le substrat 102 suite à une étape d'hydrogénation du substrat 102, par exemple par plasma, mise en oeuvre durant le procédé. Cette étape peut être réalisée par exemple avant et/ou après le dépôt de la couche antireflet 106.

Comme représenté sur la figure 2A, des métallisations 110, par exemple à base d'argent, sont réalisées par exemple par sérigraphie sur la face avant 108 de la cellule photovoltaïque 100. Les métallisations 110 peuvent également être à base d'au moins un autre métal que l'argent, et formées par d'autres techniques telles que la photolithographie ou l'impression. Une couche de métallisation 112, par exemple à base d'aluminium, est réalisée sur la face arrière du substrat 102. Cette couche de métallisation 112 peut par exemple être réalisée par sérigraphie, ou encore par photolithographie ou impression.

La cellule solaire 100 est ensuite placée par exemple dans un four à passage infrarouge pour subir un premier recuit, comme représenté sur la figure 2B. Ce premier recuit est réalisé à une température comprise entre environ 700°C et 900°C, formant ainsi des contacts 114 entre les métallisations 110 et la couche N+ 104, une couche dopée P+ 118 dans le substrat 102 et une couche 116 à base d'un alliage d'aluminium et de silicium, venant remplacer la couche N+ 104 sous la couche de métallisation 112. Pour les substrats de type P, la couche dopée P+ 118 réalise la passivation de la face arrière du substrat 102 par un effet de champ arrière (BSF) repoussant des porteurs minoritaires dans le substrat 102. Lors de ce premier recuit, de l'hydrogène migre sous forme d'ions à partir de la couche antireflet 106 riche en hydrogène dans le substrat 102, réalisant une passivation des défauts cristallographiques et des impuretés du substrat 102. Ce premier recuit peut également être réalisé dans un four de recuit classique, ou par d'autres techniques de recuit connues. De préférence, ce premier recuit est réalisé à une température comprise entre environ 800°C et 900°C pendant une durée comprise entre environ 1 seconde et 10 secondes, permettant une meilleure prise de contact entre les métallisations 110 et la zone dopée N+ 104.

La cellule photovoltaïque 100 subie ensuite un second recuit, par exemple dans un four à passage infrarouge, à une température comprise entre environ 200°C et 500°C. Ce recuit ne détériore pas les métallisations 110 et 112 et permet la formation de liaisons hydrogène - impuretés ou hydrogène - défauts cristallographiques. Ces liaison permettent d'augmenter la durée de vie des porteurs du substrat, et donc d'augmenter le rendement de conversion photovoltaïque de la cellule 100.

Le tableau suivant présente des mesures de paramètres photovoltaïques (Vco : tension de circuit ouvert ; Jcc : courant de court circuit ; FF : facteur de forme ; η : rendement de conversion) de trois cellules photovoltaïques comportant chacune un substrat à base de silicium multicristallin élaboré à partir de charges de qualité métallurgique, réalisées entre le premier recuit et le second recuit, et après le second recuit. Pour ces trois cellules, le second recuit est réalisé à une température d'environ 300 °C.

| | Avant le second recuit | Après le second recuit |
|---|---|---|
| 1ère cellule | Vco = 602 mV | Vco = 604 mV |
| | Jcc = 28.4 mA/cm² | Jcc = 28.9 mA/cm² |
| | FF = 62.8 % | FF = 63.02 % |
| | η = 10.74 % | η = 11.1 % |
| 2ème cellule | Vco = 603 mV | Vco = 606 mV |
| | Jcc = 28.63 mA/cm² | Jcc = 29.1 mA/cm² |
| | FF = 62.1 % | FF = 64 % |
| | η = 10.73 % | η = 11.3 % |
| 3ème cellule | Vco = 604 mV | Vco = 605 mV |
| | Jcc = 28.51 mA/cm² | Jcc = 29.2 mA/cm² |
| | FF = 62.3 % | FF = 63.3 % |
| | η = 10.8 % | η = 11.2 % |

On observe pour ces 3 cellules qu'une augmentation moyenne du rendement de conversion de 0.44% est obtenue grâce au second recuit réalisé durant un procédé de recuit.

Ce second recuit peut également être réalisé dans un four classique, ou par d'autres techniques de recuit connues, à pression ambiante et à l'air ambiant. De préférence, ce second recuit est réalisé à une température environ égale à 300°C, pendant une durée comprise entre environ 10 secondes et 2 minutes, permettant d'améliorer la diffusion métallique des métallisations 110.

Enfin, comme représenté sur la figure 2C, on supprime les portions de la couche N+ 104 reliant la couche 118 et les contacts 114, c'est-à-dire reliant électriquement les métallisations 110 de la face avant à la couche de métallisation 112 de la face arrière. Sur la figure 2C, tous les éléments de la cellule photovoltaïque 100 se trouvant du côté extérieur des plans AA et BB sont supprimés, par exemple par laser, plasma, enrobage, ou tout autre moyen de gravure.

Ce second recuit peut également être mis en oeuvre durant un procédé de réalisation d'une cellule photovoltaïque comportant les étapes de réalisation décrites précédemment. Il est possible que la cellule photovoltaïque subisse plus de deux recuits, le second recuit cité précédemment devenant par exemple un troisième ou un quatrième recuit.

Le procédé selon l'invention convient également particulièrement à la réalisation de cellules photovoltaïques comportant des substrats de type N. Dans ce cas, la couche dopée P+ 118 joue le rôle d'émetteur de la jonction PN de la cellule photovoltaïque. La couche dopée N+ 104 réalise alors la passivation de la face avant du substrat 102 par un effet de champ avant (FSF) repoussant des porteurs minoritaires dans le substrat 102, la couche antireflet 106 contribuant également à cette passivation. Il est également possible que la couche dopée du second type de conductivité 104 soit une couche dopée P+, obtenue par exemple par diffusion de bore dans le substrat 102.

## Revendications

1. Procédé de recuit d'au moins une cellule photovoltaïque (100) comportant un substrat (102) à base de silicium d'un premier type de conductivité, une couche (104) dopée d'un second type de conductivité réalisée dans le substrat (102) et formant une face avant du substrat (102), une couche (106) antireflet réalisée sur la face avant du substrat (102) et formant une face avant (108) de la cellule photovoltaïque (100), au moins une métallisation (110) sur la face avant (108) de la cellule photovoltaïque (100) et au moins une métallisation sur une face arrière du substrat (102), ledit procédé comportant au moins les étapes de :
a) premier recuit de la cellule photovoltaïque (100) à une température comprise entre environ 700°C et 900°C,
b) second recuit de la cellule photovoltaïque (100) à une température comprise entre environ 200°C et 500°C, à pression ambiante et à l'air ambiant,
de l'hydrogène étant diffusé dans le substrat (102) durant le procédé.

2. Procédé selon la revendication 1, la couche antireflet (106) étant riche en hydrogène.

3. Procédé selon l'une des revendications précédentes, l'hydrogène diffusé dans le substrat (102) étant obtenu par une étape d'hydrogénation du substrat (102) .

4. Procédé selon l'une des revendications précédentes, le premier et/ou le second recuit étant réalisés dans un four à passage infrarouge.

5. Procédé selon l'une des revendications précédentes, la couche (104) dopée du second type de conductivité étant une couche dopée N+.

6. Procédé selon l'une des revendications précédentes, la couche antireflet (106) étant à base de nitrure de silicium.

7. Procédé selon l'une des revendications précédentes, le substrat (102) étant un substrat à base de silicium multicristallin.

8. Procédé selon l'une des revendications précédentes, la métallisation (110) réalisée sur la face avant (108) de la cellule photovoltaïque (100) étant à base d'argent.

9. Procédé selon l'une des revendications précédentes, la métallisation (112) réalisée sur la face arrière du substrat (102) étant à base d'aluminium.

10. Procédé selon l'une des revendications précédentes, la métallisation (110) en face avant et/ou la métallisation (112) en face arrière étant réalisées par sérigraphie.

11. Procédé de réalisation d'au moins une cellule photovoltaïque (100), comportant au moins les étapes de :
- texturation des surfaces d'un substrat (102) à base de silicium d'un premier type de conductivité,
- formation d'une couche (104) dopée d'un second type de conductivité dans le substrat (102) formant une face avant du substrat (102),
- dépôt d'une couche (106) antireflet sur la face avant du substrat (102), ladite couche (106) formant une face avant (108) de la cellule photovoltaïque (100),
- réalisation d'au moins une métallisation (110) sur la face avant (108) de la cellule photovoltaïque (100),
- réalisation d'au moins une métallisation (112) sur une face arrière du substrat (102),
- mise en oeuvre d'un procédé de recuit selon l'une des revendications 1 à 10,
- suppression d'au moins une partie de la couche (104) dopée du second type de conductivité reliant électriquement la métallisation (110) de la face avant (108) à la métallisation (112) de la face arrière de la cellule photovoltaïque (100) .

12. Procédé selon la revendication 11, lorsque l'hydrogène diffusé dans le substrat (102) est obtenu à partir d'une étape d'hydrogénation du substrat (102), cette étape d'hydrogénation est réalisée avant et/ou après le dépôt de la couche antireflet (106).

13. Procédé selon l'une des revendications 11 ou 12, l'étape de texturation étant réalisée avec une solution à base d'hydroxyde de potassium.

14. Procédé selon l'une des revendications 11 à 13, la couche dopée d'un second type de conductivité (104) étant une couche dopée N+ formée par diffusion de phosphore dans le substrat (102).

15. Procédé selon l'une des revendications 11 à 14, la couche antireflet (106) étant une couche à base de nitrure de silicium déposée par PECVD.

## Patentansprüche

1. Verfahren zum Tempern wenigstens einer photovoltaischen Zelle (100), umfassend ein Substrat (102) auf Basis von Silizium mit einem ersten Leitfähigkeitstyp, eine Schicht (104), die mit einem zweiten Leitfähigkeitstyp dotiert und in dem Substrat (102) realisiert ist, die eine Vorderfläche des Substrats (102) bildet, eine Antireflexionsschicht (106), die auf der Vorderfläche des Substrats (102) realisiert ist und eine Vorderfläche (108) der photovoltaischen Zelle (100) bildet, wenigstens eine Metallisierung (110) auf der Vorderfläche (108) der photovoltaischen Zelle (100), sowie wenigstens eine Metallisierung auf einer Rückfläche des Substrats (102), wobei das Verfahren wenigstens die folgenden Schritte umfasst:
a) erstes Tempern der photovoltaischen Zelle (100) bei einer Temperatur, die zwischen ungefähr 700°C und 900°C enthalten ist,
b) zweites Tempern der photovoltaischen Zelle (100) bei einer Temperatur, die zwischen ungefähr 200°C und 500°C enthalten ist, bei Umgebungsdruck und an Umgebungsluft,
wobei während des Verfahrens Wasserstoff in das Substrat (102) diffundiert wird.

2. Verfahren nach Anspruch 1, wobei die Antireflexionsschicht (106) reich an Wasserstoff ist.

3. Verfahren nach einem der vorhergehenden Ansprüche, wobei der in das Substrat (102) diffundierte Wasserstoff durch einen Schritt der Hydrierung des Substrats (102) erhalten wird.

4. Verfahren nach einem der vorhergehenden Ansprüche, wobei das erste und/oder das zweite Tempern in einem Infrarot-Durchlaufofen realisiert werden.

5. Verfahren nach einem der vorhergehenden Ansprüche, wobei die mit dem zweiten Leitfähigkeitstyp dotierte Schicht (104) eine N+-dotierte Schicht ist.

6. Verfahren nach einem der vorhergehenden Ansprüche, wobei die Antireflexionsschicht (106) auf Basis von Siliziumnitrid ist.

7. Verfahren nach einem der vorhergehenden Ansprüche, wobei das Substrat (102) ein Substrat auf Basis von multikristallinem Silizium ist.

8. Verfahren nach einem der vorhergehenden Ansprüche, wobei die auf der Vorderfläche (108) der photovoltaischen Zelle (100) realisierte Metallisierung (110) auf Basis von Silber ist.

9. Verfahren nach einem der vorhergehenden Ansprüche, wobei die auf der Rückfläche des Substrats (102) realisierte Metallisierung (112) auf Basis von Aluminium ist.

10. Verfahren nach einem der vorhergehenden Ansprüche, wobei die Metallisierung (110) auf der Vorderfläche und/oder die Metallisierung (112) auf der Rückfläche durch Siebdruck realisiert werden.

11. Verfahren zur Herstellung wenigstens einer photovoltaischen Zelle (100), umfassend wenigstens die folgenden Schritte:
- Texturierung der Oberflächen eines Substrats (102) auf Basis von Silizium mit einem ersten Leitfähigkeitstyp,
- Bildung einer Schicht (104), die mit einem zweiten Leitfähigkeitstyp dotiert ist, in dem Substrat (102) zur Bildung einer Vorderfläche des Substrats (102),
- Aufbringen einer Antireflexionsschicht (106) auf der Vorderfläche des Substrats (102), wobei die Schicht (106) eine Vorderfläche (108) der photovoltaischen Zelle (100) bildet,
- Realisieren wenigstens einer Metallisierung (110) auf der Vorderfläche (108) der photovoltaischen Zelle (100),
- Realisieren wenigstens einer Metallisierung (112) auf einer Rückfläche des Substrats (102),
- Durchführen eines Temperverfahrens nach einem der Ansprüche 1 bis 10,
- Entfernen wenigstens eines Teils der mit dem zweiten Leitfähigkeitstyp dotierten Schicht (104), die elektrisch die Metallisierung (110) der Vorderfläche (108) mit der Metallisierung (112) der Rückfläche der photovoltaischen Zelle (100) verbindet.

12. Verfahren nach Anspruch 11, wobei wenn der in das Substrat (102) diffundierte Wasserstoff ausgehend von einem Schritt der Hydrierung des Substrats (102) erhalten wird, dieser Schritt der Hydrierung vor und/oder nach dem Aufbringen der Antireflexionsschicht (106) durchgeführt wird.

13. Verfahren nach einem der Ansprüche 11 oder 12, wobei der Schritt der Texturierung mit einer Lösung auf Basis von Kaliumhydroxid durchgeführt wird.

14. Verfahren nach einem der Ansprüche 11 bis 13, wobei die mit einem zweiten Leitfähigkeitstyp dotierte Schicht (104) eine N+-dotierte Schicht ist, die durch Diffusion von Phosphor in das Substrat (102) gebildet ist.

15. Verfahren nach einem der Ansprüche 11 bis 14, wobei die Antireflexionsschicht (106) eine Schicht auf Basis von Siliziumnitrid ist, die durch PECVD aufgebracht wird.

## Claims

1. Method for annealing at least one photovoltaic cell (100) comprising a substrate (102) comprising silicon with a first type of conductivity, a layer (104) doped with a second type of conductivity produced in the substrate (102) and forming a front face of the substrate (102), an antireflection layer (106) produced on the front face of the substrate (102) and forming a front face (108) of the photovoltaic cell (100), at least one metallization (110) on the front face (108) of the photovoltaic cell (100) and at least on metallization on a rear face of the substrate (102), said method comprising at least the steps of:
a) a first annealing of the photovoltaic cell (100) at a temperature between around 700°C and 900°C,
b) a second annealing of the photovoltaic cell (100) at a temperature between around 200°C and 500°C, at ambient pressure and in ambient air,
with hydrogen being diffused in the substrate (102) during the process.

2. Method according to claim 1, the antireflection layer (106) being rich in hydrogen.

3. Method according to one of the previous claims, the hydrogen diffused in the substrate (102) being obtained by a step of hydrogenation of the substrate (102).

4. Method according to one of the previous claims, the first and/or the second annealing operation being performed in an infrared passage furnace.

5. Method according to one of the previous claims, the layer (104) doped with the second type of conductivity being an N+ doped layer.

6. Method according to one of the previous claims, the antireflection layer (106) comprising silicon nitride.

7. Method according to one of the previous claims, the substrate (102) being a substrate comprising multicrystalline silicon.

8. Method according to one of the previous claims, the metallization (110) produced on the front face (108) of the photovoltaic cell (100) comprising silver.

9. Method according to one of the previous claims, the metallization (112) produced on the rear face of the substrate (102) comprising aluminium.

10. Method according to one of the previous claims, the metallization (110) on the front face and/or the metallization (112) on the rear face being made by serigraphy.

11. Method for producing at least one photovoltaic cell (100), comprising at least the steps of:
- texturising the surfaces of a substrate (102) comprising silicon with a first type of conductivity,
- forming a layer (104) doped with a second type of conductivity in the substrate (102) forming a front face of the substrate (102),
- depositing an antireflection layer (106) on the front face of the substrate (102), which layer (106) forms a front face (108) of the photovoltaic cell (100),
- producing at least one metallization (110) on the front face (108) of the photovoltaic cell (100),
- producing at least one metallization (112) on a rear face of the substrate (102),
- implementing an annealing method according to one of claims 1 to 10,
- removing at least a portion of the layer (104) doped with the second type of conductivity electrically connecting the metallization (110) of the front face (108) to the metallization (112) of the rear face of the photovoltaic cell (100).

12. Method according to claim 11, when the hydrogen diffused in the substrate (102) is obtained from a step of hydrogenation of the substrate (102), said hydrogenation step being performed before and/or after the deposition of the antireflection layer (106).

13. Method according to one of claims 11 or 12, the texturisation step being performed with a potassium hydroxide-based solution.

14. Method according to one of claims 11 to 13, the layer doped with a second type of conductivity (104) being an N+ layer formed by the diffusion of phosphorus in the substrate (102).

15. Method according to one of claims 11 to 14, the antireflection layer (106) being a silicon nitride-based layer deposited by PECVD.
